## Europäisches Patentamt

## European Patent Office

## Office européen des brevets

(19)

(11) Veröffentlichungsnummer: **0 036 898 B1**

(12) **EUROPÄISCHE PATENTSCHRIFT**

(45) Veröffentlichungstag der Patentschrift:
**31.10.84**

(51) Int. Cl.³: **C 23 C 13/00, C 23 C 15/00**

(21) Anmeldenummer: **80101648.6**

(22) Anmeldetag: **27.03.80**

(54) Verfahren zur Herstellung von Verbundwerkstoffen, bestehend aus Substraten und aus auf deren Oberflächen festhaftenden, metallischen Schichten metastabiler oder instabiler Phasen.

(43) Veröffentlichungstag der Anmeldung:
**07.10.81 Patentblatt 81/40**

(45) Bekanntmachung des Hinweises auf die Patenterteilung:
**31.10.84 Patentblatt 84/44**

(84) Benannte Vertragsstaaten:
**CH DE FR GB IT NL SE**

(56) Entgegenhaltungen:
**US - A - 4 128 121**
**US - A - 4 129 166**
**US - A - 4 129 167**

(73) Patentinhaber: **Kernforschungszentrum Karlsruhe GmbH, Weberstrasse 5, D-7500 Karlsruhe 1 (DE)**

(72) Erfinder: **Krevet, Berthold, Dr., Strohmorgen 5, D-7521 Dettenheim-Liedolsheim (DE)**
Erfinder: **Schauer, Wolfgang, Dr., Tannenstrasse 30, D-7507 Pfinztal 1 (DE)**
Erfinder: **Wüchner, Fritz, Bahnhofstrasse 36, D-6728 Germersheim (DE)**

BUNDESDRUCKEREI BERLIN

## Beschreibung

Die Erfindung betrifft ein Verfahren zur Herstellung von Verbundwerkstoffen, bestehend aus Substraten und aus auf deren Oberflächen festhaftenden, metallischen Schichten metastabiler oder instabiler, mehr als ein Element enthaltender Phasen, bei welchem die Phasen aus einem Gas- bzw. Dampfraum auf die Substratoberflächen aufgebracht werden.

Bei den bisher beschriebenen Verfahren zur Herstellung von metallischen Schichten metastabiler oder instabiler, stöchiometrischen Verbindungen, speziell Phasen mit A15-Struktur, wurden die Komponenten der Verbindung auf Substrate aufkondensiert, die zuvor auf verhältnismäßig hohe, zur Bildung der metastabilen Verbindungen erforderliche Temperatur erhitzt worden sind. Beispielsweise wurde zur Präparation der metastabilen A15-Verbindung $Nb_3Ge$ Niob und Germanium auf ca. 1073 K heiße Substrate aufgebracht. Auf diese Weise lassen sich bei Einhaltung gewisser Verfahrensbedingungen metastabile Phasen mit Supraleitungseigenschaften erzeugen, die reproduzierbare Übergangstemperaturen um 21 K aufweisen. An Versuchen, sehr hohe Übergangstemperaturen um 23 K zu erreichen, hat es nicht gefehlt. Es wurden auch hin und wieder supraleitende Schichten mit Übergangstemperaturen zwischen 22 und 23 K erhalten, doch waren diese nicht reproduzierbar herzustellen. Es wurde vermutet, daß die für die Supraleitfähigkeit verantwortliche A15-Phase durch Zusatz von Verunreinigungen während des Wachstumsprozesses stabilisiert werden würde, doch reichte dies zum Verständnis der Vorgänge bei der Bildung beispielsweise der $Nb_3Ge$-Phase, insbesondere an der Grenzschicht zum Substrat hin, nicht aus.

Zur Herstellung eines supraleitenden Films mit einer kritischen Temperatur $T_c$ von wenigstens 20 K auf einem Substrat wurde vorgeschlagen (US-A-4 128 121), in eine evakuierte Kammer, in welcher ein $Nb_3Ge$-Film aus der Dampfphase der Verbindungspartner Nb und Ge auf dem inerten Substrat abgeschieden werden soll, eine Sauerstoffquelle zu geben, so daß nach dem Aufheizen des Substrats auf Temperaturen zwischen 1023 K und 1373 K ein Sauerstoffpartialdruck zwischen etwa $1,33 \cdot 10^{-7}$ mbar bis ungefähr $1,33 \cdot 10^{-5}$ mbar aufgebaut wird und während der Abscheidung der gesamten Schichtdicke aufrechterhalten wird. Höhere Werte für die kritische Temperatur $T_c$ als 20 K (wie z. B. 22 oder 23 K) wurden mit dem Verfahren gemäß der US-Patentschrift nicht erhalten bzw. in dieser Druckschrift nicht offenbart.

Es wurde gefunden, daß mit Hilfe des Kathodenzerstäubungsverfahrens auf einer Substratoberfläche aufkondensierte $Nb_3Ge$-Filme mit einer Dicke von 100 nm oder dünner die maximal erreichbare Übergangstemperatur zwischen 22 K und 23 K nicht mehr aufwiesen, wie sie in dickeren Filmen gemessen wurden (J. R. Gavaler et al., Appl. Phys. Lett. 33, No. 4, 1978, S. 359 bis 361). Während bei $Nb_3Ge$-Filmen von einer Dicke unter 100 nm auf Saphir-Substraten Übergangstemperaturen ($T_c$) zwischen 14 und 17 K und unerwartet große Gitter-Parameter festgestellt wurden, konnten bei zunehmendem Wachstum der Filmdicke kleinere Gitter-Parameter und Übergangstemperaturen von ca. 22 bis 23 K ermittelt werden. Nachdem eine Anzahl von Daten (aus verschiedenen Laboratorien) vorlag, die zeigten, daß die Anwesenheit von Verunreinigungen während des Wachstumsprozesses der A15-Phase einen günstigen Effekt auf die Bildung von stöchiometrischem $Nb_3Ge$ mit hohem $T_c$ ausübt, haben Gavaler et al mit Niob-Germanium beschichtete Substrate wie Saphir, $Al_2O_3$, Hastelloy B, Tantal- und Vanadium-Folien und, in einigen Fällen, mit Luft bei 873 K an der Oberfläche oxidierte Tantal- und Vanadium-Folien untersucht. Hierbei wurden gefunden:

| | |
|---|---|
| $Nb_3Ge$ auf reinem Ta-Substrat: | $T_c$ ca. 13 K |
| $Nb_3Ge$ auf oxidiertem Ta-Substrat: | $T_c$ ca. 21,5 K |
| $Nb_3Ge$ auf Vanadium-Substrat: | $T_c$ ca. 13 K |
| $Nb_3Ge$ auf $Al_2O_3$-Substrat: | $T_c$ ca. 22 k. |

Die bisher nicht gelösten Schwierigkeiten bei der Reproduzierbarkeit in der Herstellung von A15-Phasen mit hohen Übergangstemperaturen (um 23 K) wurden auch von R. E. Somekh (Phylosophical Magazine B Vol. 37, No. 6, 1978, Seiten 713 bis 730) erwähnt. In diesem Aufsatz wurde festgestellt, daß es außer dem Einfluß von Sauerstoff auf die Bildung der $Nb_3Ge$-Phase noch weitere Parameter geben müsse, die bisher noch nicht identifiziert worden seien.

Der Erfindung liegt die Aufgabe zugrunde, ein Verfahren zu schaffen, mit welchem metallische Schichten metastabiler oder instabiler Phasen auf Oberflächen von Substraten festhaftend aufgebracht und auf diese Weise Werkstoffe mit verbesserten und reproduzierbaren physikalischen Eigenschaften, insbesondere Supraleitungseigenschaften, hergestellt werden können. Beispielsweise sollen Dünnschicht-Supraleiter mit A15-Struktur und hoher Übergangstemperatur zwischen 22 K und 23 K oder darüber in gleichbleibender Qualität mit dem erfindungsgemäßen Verfahren herstellbar sein.

Diese Aufgabe wird erfindungsgemäß dadurch gelöst, daß

a) man zur Bildung der Phase sehr reine Komponenten mit Verunreinigungskonzentrationen von jeweils weniger als 100 ppm verwendet,

b) man während des Anfangswachstums der Phase (innerhalb eines Dickenbereiches zwischen 5 nm und 20 nm) zur Förderung der Keimbildung die Mobilität der Phasenkomponenten auf der Substratoberfläche reduziert, entweder

b₁) durch Kondensation der Komponenten auf das kalte Substrat im Temperaturbereich ≤ Raumtemperatur, oder

b₂) durch Zusatz einer gezielten Verunreinigung aus der Gruppe Sauerstoff und sauerstoffhaltige Verbindungen, und

c) man danach die Phasenkomponenten für die restliche Schicht bis zur gewünschten Dicke auf das erhitzte Substrat aufkondensiert.

Der Zusatz von Sauerstoff erfolgt durch Einstellen eines Sauerstoff-Partialdruckes im Gasbzw. Dampfraum, der so groß ist, daß das Sauerstoffangebot auf dem Substrat dem Angebot der Komponenten vergleichbar ist. Als gezielte Verunreinigung kann ein sauerstoffhaltiges Gas verwendet werden. Zur Reduzierung der Mobilität der Phasenkomponenten auf der Substratoberfläche kann man auch vor dem Aufbringen der reinen Komponenten die Substratoberfläche mit einer 5 bis 20 nm dicken Schwermetalloxidschicht belegen.

Eine besondere Ausbildung der Erfindung ist dadurch gekennzeichnet, daß man

a) hoch gereinigtes Niob und hoch-reines Germanium in einem Ultrahochvakuum von ≤ 10⁻⁸ mbar Restgasdruck mit Hilfe eines Elektronenstrahlverdampfungsverfahrens oder eines Kathodenzerstäubungsverfahrens zur Schichtpräparation verwendet,

b) dieses Niob und Germanium mit einem Atom-Verhältnis Niob zu Germanium von 3 : 1 bei oder unterhalb Raumtemperatur auf einem Substrat aus Saphir bis zu einer Schichtdicke im Bereich zwischen 5 nm und 20 nm in Form einer kristallographisch stark gestörten bzw. amorphen Schicht abscheidet,

c) danach das Substrat auf eine Temperatur im Bereich von 1073 K bis 1273 K aufheizt und Niob und Germanium unter sonst beibehaltenen Bedingungen (außer der Temperatur) auf der unter b) erzeugten Schicht zur Bildung einer A-15 Phase von metastabilem Nb₃Ge bis zu einer gewünschten Schichtdicke aufwachsen läßt.

Es war der Fachwelt bekannt, daß die Anwesenheit von Verunreinigungen, insbesondere die Anwesenheit von Sauerstoff, während des Wachstumsprozesses einen begünstigenden Effekt auf die Bildung von Nb₃Ge ausübt. Da Niob in der Regel genügend geeignete Verunreinigungen enthält, ist die Keimbildung der A15-Phase gewährleistet und es lassen sich Übergangstemperaturen um 21 K erzielen. Zum Erreichen sehr hoher Sprungtemperaturen um 23 K ist jedoch die Verwendung von sehr reinen Ausgangsmaterialien erforderlich. Hierbei ist allerdings die Keimbildung der A15-Phase nicht mehr gewährleistet. Es wurde nun bei Untersuchungen über die Keimbildung von Nb₃Ge gefunden, daß die A15-Phase aus einer amorphen Niob-Germaniumschicht mit reduzierter Beweglichkeit der Komponenten herauswächst. Unter sehr sauberen Herstellungsbedingungen (Ultrahochvakuum im Bereich von ≤ 10⁻⁸ mbar, Verwendung von Reinstmaterialien mit Verunreinigungskonzentrationen von weniger als 10 ppm) bildet sich diese amorphe Anfangsschicht, hergestellt mit Hilfe eines Elektronenstrahlverdampfungsverfahrens ohne Anwendung des erfindungsgemäßen Verfahrens, nicht mehr aus. Da ganz allgemein die Herstellung der A15-Phase bei hohen Substrattemperaturen (1073 K bis 1273 K) erfolgt, haben die aufgedampften Atome auf der Substratoberfläche eine ausreichende Beweglichkeit, um sich zu entmischen und somit die Bildung einfacher kubischer Phasen, insbesondere von Niob, zu ermöglichen. Wenn Niobausscheidungen entstanden sind, so können diese epitaktisch weiterwachsen und die Ausbildung der A15-Phase behindern. Tritt zu Beginn der Bedampfung eine solche Entmischung ein, dann kann sich nur eine A15-Phase mit niedrigeren $T_c$-Werten (14 K) und niedrigem Ordnungsgrad ausbilden.

Die bevorzugte Bildung der metastabilen A15-Phase der Form A₃B gegenüber dem thermodynamischen Gleichgewichtszustand aus einer anfänglichen ungeordneten, homogenen Mischung der A- und B-Atome kann aus Energie Betrachtungen qualitativ verstanden werden. Der thermodynamische Gleichgewichtszustand des Systems mit 25 Atom-% B-Anteil besteht aus zwei Phasen, im Fall Niob-Germanium aus der unterstöchiometrischen A15-Phase und der Nb₅Ge₃-Phase, im Fall Niob-Silizium aus Niob und Nb₅Si₃. In diesen Fällen erfordert die Bildung der metastabilen A15-Phase A₃B eine niedrige Aktivierungsenergie als der Zwei-Phasen-Zustand, da zur Ausbildung des Zwei-Phasen-Gemisches sowohl Entmischungsenergie (Umordnung durch Diffusion) als auch Energie zum Aufbau von Phasengrenzflächen aufgebracht werden muß. Wesentlich dabei ist, daß eine homogene Mischung der A- und B-Atome im Verhältnis 3 : 1 zur Ausbildung einer hinreichend dicken, ungeordneten Anfangsschicht gewährleistet ist. Eine konstante Kondensationsrate der A- und B-Atome auf dem Substrat ist zwar eine notwendige, nicht aber eine hinreichende Bedingung hierfür: Die Beweglichkeit der aufgedampften Atome muß außerdem reduziert werden. Es konnte gezeigt werden, daß das Auskristallisieren in die stöchiometrische A15-Phase aus dem amorphen Zustand durch Ausheilen der amorphen Niob-Germanium-Proben bei 1123 K erfolgt, die durch Aufdampfen auf mit flüssigem Stickstoff gekühlte Substrate hergestellt werden.

Das Zusammenwirken einerseits des Aufdampfens von sehr reinen Komponenten auf das Substrat und andererseits der Reduzierung der Beweglichkeiten der aufgedampften Atome auf dem Substrat mit den bekannten Bedingungen für das Wachstum der A15-Phasen gewährleistet die Reproduzierbarkeit der Herstellung von Verbundwerkstoffen, die aus Substraten und aus auf diesen festhaftenden metastabilen oder instabilen Phasen bzw. Schichten bestehen.

Die Reduzierung der Mobilität der Phasen-Komponenten bzw. der aufgedampften Atome auf der Substratoberfläche kann auf verschiedene Weise erzwungen werden:

1. Das Aufdampfen der Atome wird auf ein kaltes Substrat vorgenommen, das sowohl Raumtemperatur aufweisen kann als auch eine darunter liegende Temperatur bis zu der des flüssigen Heliums.

2. In den Dampfraum wird zu Beginn der Schichtpräparation Sauerstoff oder ein sauerstoffhaltiges Gas, wie z. B. $CO_2$, in einer Menge eingeführt, die einem den Aufdampfraten der Phasen- Komponenten vergleichbaren Teilchenangebot entspricht.

3. Die Substratoberfläche wird vor dem Aufbringen der reinen Phasen-Komponenten zunächst mit einer 5 bis 20 nm dicken hochschmelzenden Metalloxid-Schicht belegt, z. B. mit einer Chromoxid- oder Tantaloxid-Schicht.

Wird das Aufdampfen der Phasen-Komponenten auf das Substrat mit Hilfe eines Elektronenstrahlverdampfungsverfahrens durchgeführt, so kann im Falle eines Sauerstoffzusatzes im Reaktionsgefäß ein Sauerstoffpartialdruck von $10^{-6}$ bis $10^{-7}$ mbar eingestellt werden. Wird ein Kathodenzerstäubungsverfahren angewendet, bei welchem bekanntermaßen mit Edelgasen gearbeitet wird, setzt man Sauerstoff oder ein sauerstoffhaltiges Gas in einer entsprechenden Menge ($10^{-6}$ bis $10^{-7}$ mbar Partialdruck) ein.

Besonders vorteilhaft ist die Durchführung des erfindungsgemäßen Verfahrens, bei welcher die Kondensation der Phasen-Komponenten auf ein kaltes Substrat erfolgt, da es die Präparation von $Nb_3Ge$ gestattet, ohne daß Verunreinigungen durch Diffusion in die A15-Phase gelangen können.

Die Erfindung wird im folgenden in einigen Ausführungsbeispielen näher erläutert.

## Ausführungsbeispiele

Der Einfluß der Materialreinheit auf die Übergangstemperatur $T_c$ von $Nb_3Ge$ wurde an 600 nm dicken Schichten untersucht, da hier die Abhängigkeit der Übergangstemperatur von der Schichtdicke nur noch gering ist. Bei Verwendung von Nb und Ge mit Verunreinigungen $< 10$ ppm konnten mit den anschließend beschriebenen keimbildungsfördernden Maßnahmen $T_c$-Werte von 23 K für Schichtdicken $\geq 600$ nm erreicht werden. Wird dagegen Nb mit einem Ta-Gehalt von 900 ppm (gemessen mit einer Aktivierungsanalyse) verwendet, so lassen sich nur noch $T_c$-Werte von 20,9 K erzielen.

## Ausführungsbeispiel 1

### $Nb_3Ge$ auf oxidierter Schwermetall-Unterlage

Als Substrate wurden einkristalline, willkürlich orientierte Saphire der Abmessungen $50 \cdot 5 \cdot 1$ mm gewählt, von denen 20 Stück parallel auf ein Heizband mit Klemmbügeln fixiert wurden. Jedes geradzahlige Substrat (Nr. 2, 4, 6, . . .) war zuvor mit einer 15 nm dicken Chromauflage durch Kathodenzerstäubung beschichtet worden, die durch den Luftsauerstoff oxidiert wurde. Die ungradzahligen Substrate waren blanke Saphire. Die beiden Verdampferquellen (Nb- und Ge-Tiegel) hatten einen Abstand von ca. 20 cm. Parallel zu ihrer Verbindungslinie im Abstand von ca. 50 cm über ihnen wurde das mit den Substraten belegte Heizband montiert. Durch diese Anordnung ergab sich eine Variation im Nb : Ge-Verhältnis der Aufdampfproben, wobei das stöchiometrische 3 : 1 Nb : Ge-Verhältnis im Bereich der Probenpositionen 8 bis 12 lag, unterhalb Position Nr. 8 wurden Proben mit Nb-Überschuß, oberhalb Position Nr. 12 Proben mit Ge-Überschuß hergestellt.

Die Saphiroberflächen wurden auf eine Temperatur von 1123 K gebracht (infrarotspektrometrisch gemessen). Die Elektronenstrahlverdampfung aus dem Nb- und Ge-Tiegel wurde massenspektrometrisch auf Ratenkonstanz kontrolliert und so lange vorgenommen, bis eine 200 nm dikke $Nb_3Ge$-Schicht aufgewachsen war. Die Verdampfungsmaterialien waren von höchster Reinheit ($< 10$ ppm Verunreinigungen). Der Druck im Rezipienten lag bei $10^{-8}$ mbar.

### Ergebnis:

Das simultane Verdampfen von Nb und Ge auf die alternierend angeordneten Cr-vorbeschichteten und blanken Saphire zeigten bei den Cr vorbeschichteten Proben, verglichen mit den blanken Saphiren, um bis zu 10 K höhere Übergangstemperaturen, sowie geringere Übergangsbreiten und höhere Restwiderstände, was die bevorzugte Ausbildung der geordneten hoch-$T_c$ A15-Phase $Nb_3Ge$ beweist. Für die stöchiometrische 3 : 1-Zusammensetzung wurden 22,5 K Übergangstemperatur auf vorbeschichtetem Saphir erreicht.

### Ausführungsbeispiel (2)

### $Nb_3Ge$ mit anfänglichem Sauerstoffzusatz

Experimentelle Anordnung und Präparationsbedingungen sind die gleichen wie in Ausführungsbeispiel (1) beschrieben. Es wurden jedoch ausschließlich blanke Saphire verwendet. Zusätzlich wurde eine Blende montiert, die alle Substrate halbseitig abdecken kann.

Bei der Präparation waren die Substrate zunächst zur Hälfte abgedeckt. Auf die freien Saphirhälften wurde dann eine ca. 5 nm dicke $Nb_3Ge$-Schicht bei einem Sauerstoffpartialdruck von $7 \cdot 10^{-7}$ mbar aufgedampft. Danach wurde durch Schließen des Sauerstoff-Dosierventils der Gesamtdruck auf $5 \cdot 10^{-8}$ mbar abgesenkt. Währenddessen wurden weitere 2,5 nm $Nb_3Ge$ aufgedampft. Danach wurde die Blende geöffnet und auf den gesamten Saphir eine ca. 80 nm dicke $Nb_3Ge$-Schicht aufgedampft.

## Ergebnis

Bei der Substratposition 9, die der stöchiometrischen 3 : 1-Zusammensetzung entspricht, wurde (trotz der geringen Schichtdicke von 80 nm) eine Übergangstemperatur von 21,7 K bei anfänglicher Sauerstoffzugabe erreicht. Die Saphirhälften, auf die ohne anfänglichen Sauerstoffzusatz $Nb_3Ge$ aufgedampft worden war, zeigten demgegenüber nur eine Übergangstemperatur von 17,8 K mit reduziertem Widerstandsverhältnis und nachgewiesener Ausbildung von Fremdphasen.

## Ausführungsbeispiel (3)

### $Nb_3Ge$ auf amorpher NbGe-Schicht

Experimentelle Anordnung und Präparationsbedingungen sind die gleichen wie in Ausführungsbeispiel (1) beschrieben. Zunächst wurden die Substrate jedoch kalt mit ungeordnetem, nicht kristallinem NbGe vorbeschichtet.

Die Dicke der kalt (bei Raumtemperatur) aufgedampften Schicht betrug etwa 20 nm, danach wurden insgesamt noch einmal 80 nm aufgedampft, davon etwa 40 nm während der Erhöhung der Substrattemperatur von 300 K auf 1123 K. Bei der optimalen Präparationstemperatur wurden also nur 40 nm aufgedampft.

## Ergebnis

Die stöchiometrische Probe hat eine Übergangstemperatur von 22 K; ihr Widerstandsverhältnis beträgt 1,5. Ein Vergleich mit den auf blankem Saphir erreichten $T_c$-Werten, wenn die Substrattemperatur schon zu Beginn der Kondensation hoch ist (vergleiche Ausführungsbeispiel (1)), zeigt, daß eine deutliche Verbesserung der Keimbildung der A15-Phase erreicht wurde.

## Patentansprüche

1. Verfahren zur Herstellung von Verbundwerkstoffen, bestehend aus Substraten und aus auf deren Oberflächen festhaftenden, metallischen Schichten metastabiler oder instabiler, mehr als ein Element enthaltender Phasen, bei welchem die Phasen aus einem Gas- bzw. Dampfraum auf die Substratoberflächen aufgebracht werden, dadurch gekennzeichnet, daß

a) man zur Bildung der Phase sehr reine Komponenten mit Verunreinigungskonzentrationen von jeweils weniger als 100 ppm verwendet,

b) man während des Anfangswachstums der Phase (innerhalb eines Dickenbereichs zwischen 5 nm und 20 nm) zur Förderung der Keimbildung die Mobilität der Phasenkomponenten auf der Substratoberfläche reduziert, entweder

$b_1$) durch Kondensation der Komponenten auf das kalte Substrat im Temperaturbereich $\leq$ Raumtemperatur, oder

$b_2$) durch Zusatz einer gezielten Verunreinigung aus der Gruppe Sauerstoff und sauerstoffhaltige Verbindungen, und

c) man danach die Phasenkomponenten für die restliche Schicht bis zur gewünschten Dicke auf das erhitzte Substrat aufkondensiert.

2. Verfahren nach Anspruch 1, dadurch gekennzeichnet, daß der Zusatz von Sauerstoff durch Einstellen eines Sauerstoff-Partialdruckes im Gas- bzw. Dampfraum erfolgt, der so groß ist, daß das Sauerstoff-Angebot auf dem Substrat dem Angebot der Komponenten vergleichbar ist.

3. Verfahren nach Anspruch 1, dadurch gekennzeichnet, daß als gezielte Verunreinigung sauerstoffhaltiges Gas verwendet wird.

4. Verfahren nach Anspruch 1, dadurch gekennzeichnet, daß man zur Reduzierung der Mobilität der Phasenkomponenten auf der Substratoberfläche vor dem Aufbringen der reinen Komponenten die Substratoberfläche mit einer 5 bis 20 nm dicken Schwermetalloxid-Schicht belegt.

5. Verfahren nach Anspruch 1, dadurch gekennzeichnet, daß man

a) hoch gereinigtes Niob und hoch-reines Germanium in einem Ultrahochvakuum von $\leq 10^{-8}$ mbar Restgasdruck mit Hilfe eines Elektronenstrahlverdampfungsverfahrens oder eines Kathodenzerstäubungsverfahrens zur Schichtpräparation verwendet,

b) dieses Niob und Germanium mit einem Atom-Verhältnis Niob zu Germanium von 3 : 1 bei oder unterhalb Raumtemperatur auf einem Substrat aus Saphir bis zu einer Schichtdicke im Bereich zwischen 5 nm und 20 nm in Form einer kristallographisch stark gestörten bzw. amorphen Schicht abscheidet,

c) danach das Substrat auf eine Temperatur im Bereich von 1073 K bis 1273 K aufheizt und Niob und Germanium unter sonst beibehaltenen Bedingungen (außer der Temperatur) auf der unter b) erzeugten Schicht zur Bildung einer A15-Phase von metastabilem $Nb_3Ge$ bis zu einer gewünschten Schichtdicke aufwachsen läßt.

## Claims

1. Process for the preparation of composite materials consisting of substrates and metallic layers of metastable or instable phases containing more than one elemental component and strongly adhering to the substrate surface, the phases being deposited on the substrate surfaces from a gas and vapor space, respectively, wherein

a) very pure components are used for formation of the phase having respective impurity concentrations of less than 100 ppm;

b) during the initial phase growth (from 5 nm to 20 nm thickness) the mobility of the phase components is reduced on the substrate surface thereby promoting nucleation, either

$b_1$) by deposition through condensation of the components onto the cold substrate within the temperature range $\leq$ room temperature or

$b_2$) by addition of a specific impurity from the oxygen and oxygen bearing compounds group; and

c) the phase components for the remainder of the layer are subsequently deposited by condensation onto the heated substrate up to the desired thickness.

2. Process according to claim 1 wherein the oxygen is added by providing an oxygen partial pressure in the gas and vapor space, respectively, which is sufficiently high so that the amount of oxygen offered on the substrate is comparable to the offer by the components.

3. Process according to claim 1 wherein oxygen bearing gas is used as specific impurity.

4. Process according to claim 1 wherein for reducing the mobility of the phase components on the substrate surface prior to application of the pure components the substrate surface is coated with a 5 to 20 nm thick heavy metal oxide layer.

5. Process according to claim 1 wherein

a) highly purified niobium and high purity germanium in an ultra-high vacuum of $\leq 10^{-8}$ mbar residual gas pressure are used for preparing the layer with the help of an electron beam evaporation technique or a cathode sputtering technique;

b) this niobium and germanium with an atomic ratio 3 : 1 of niobium to germanium deposits at or below room temperature onto a sapphire substrate a crystallographically strongly disturbed and amorphous layer, respectively, up to a layer thickness of 5 nm to 20 nm;

c) the substrate is subsequently heated to a temperature of 1073 K to 1273 K and niobium and germanium, with the other conditions (except for the temperature) unchanged, are allowed to grow onto the layer produced under b) up to a desired layer thickness in order to form an A15 phase of metastable $Nb_3Ge$.

## Revendications

1. Procédé pour la préparation de matériaux composites, constitués de substrats et de couches métalliques, adhérant fortement sur leurs surfaces, de phases contenant plus d'un élément, métastables ou instables, dans lequel les phases sont appliquées sur les surfaces des substrats à partir de chambres à gaz ou à vapeurs, procédé caractérisé en ce que:

a) l'on utilise pour la formation des phases des composants très purs avec des concentrations en impuretés qui sont toujours inférieures à 100 ppm,

b) on réduit, pendant le développement initial des phases, (dans une zone d'épaisseur de 5 nm à 20 nm), la mobilité des composants de phases sur la surface des substrats, pour provoquer la formation de germes, ou bien,

$b_1$) par condensation des composants sur le substrat froid dans une plage de température ne dépassant pas la température ambiante, ou bien,

$b_2$) par addition d'une impureté voulue du groupe oxygène et composés contenant de l'oxygène, et

c) on condense ensuite les composants de phases, sur le substrat que l'on chauffe, jusqu'à l'épaisseur voulue pour le reste de la couche.

2. Procédé suivant la revendication 1, caractérisé en ce que l'addition d'oxygène s'effectue en établissant une pression partielle d'oxygène dans la chambre à gaz ou à vapeurs, pression dont l'importance est telle que l'offre d'oxygène sur le substrat est comparable à l'offre de composants.

3. Procédé suivant la revendication 1, caractérisé en ce que l'on utilise, comme impureté voulue, un gaz contenant de l'oxygène.

4. Procédé suivant la revendication 1, caractérisé en ce que, pour réduire la mobilité des composants de phases sur la surface des substrats, on garnit cette surface des substrats, avant d'y appliquer les composants purs, d'une couche de 5 à 20 nm d'épaisseur d'oxyde d'un métal lourd.

5. Procédé suivant la revendication 1, caractérisé en ce que:

a) l'on utilise, pour la préparation de la couche, du niobium hautement purifié et du germanium de grande pureté, dans un vide très poussé où la pression résiduelle de gaz est inférieure à $10^{-8}$ mbar, au moyen d'un procédé de vaporisation par faisceau d'électrons, ou d'un procédé de pulvérisation cathodique,

b) l'on dépose ce niobium et ce germanium avec un rapport atomique entre le niobium et le germanium de 3 : 1, à la température ambiante, ou en-dessous de la température ambiante, sur un substrat en saphir, jusqu'à une épaisseur de couche de l'ordre de 5 à 20 nm, sous la forme d'une couche cristallographiquement fortement perturbée ou amorphe,

c) on chauffe le substrat à une température de l'ordre de 1073 à 1273 K, et laisse se déposer le niobium et le germanium, les conditions (à part la température) restant les mêmes, sur la couche produite suivant b), pour la formation d'une phase A15 de $Nb_3Ge$ métastable, jusqu'à l'épaisseur de couche désirée.